# FASCICULE DE BREVET EUROPEEN

(11) **EP 2 915 900 B1**
(45) Date de publication et mention de la délivrance du brevet: **08.08.2018**
(21) Numéro de dépôt: 15156644.5
(22) Date de dépôt: 26.02.2015
(51) Int. Cl.: C23C 16/06, C23C 16/02, C23C 16/56, C23C 10/02, C23C 10/28, H01J 35/10, H01J 9/50

(54) **Procédé de réparation d'une anode pour l'émission de rayons X et anode réparée**
Reparaturverfahren einer Anode zur Ausstrahlung von Röntgenstrahlen, und reparierte Anode
Method for repairing an X-ray emission anode and repaired anode

(30) Priorité: 03.03.2014 FR 1451695
(43) Date de publication de la demande: 09.09.2015
(73) Titulaire: Acerde, 73800 Sainte Helene du Lac (FR)
(72) Inventeur: Huot, Guillaume, 73000 CHAMBERY (FR); Petitjean, Ariane, 38530 BARRAUX (FR); Poirel, Hervé, 38410 SAINT MARTIN D'URIAGE (FR); Robert, Pierre-Olivier, 73490 LA RAVOIRE (FR)
(74) Mandataire: Casalonga

(56) Documents cités:
- EP-A1- 0 062 380
- WO-A2-2006/117145
- WO-A2-2009/019645
- US-A- 4 700 882
- US-A1- 2009 086 919
- US-A1- 2010 092 699

## Description

La présente invention concerne le domaine des dispositifs émetteurs de rayons X, utilisés notamment pour la réalisation d'images, et plus particulièrement utilisés dans les scanners d'imagerie médicale.

La production de rayons X est obtenue par un matériau réfractaire, généralement du tungstène ou un alliage à base majoritaire de tungstène, sous l'effet d'un faisceau incident d'électrons dirigé vers et bombardant localement ce matériau.

Couramment, le matériau réfractaire se présente sous la forme d'un revêtement cible formé sur un disque en un autre matériau et s'étendant sur une zone annulaire du disque, l'ensemble étant appelé une anode. Cette anode est montée sur un arbre entraîné en rotation, de telle sorte que le faisceau incident d'électrons balaye une piste annulaire du revêtement cible annulaire en un matériau réfractaire.

Généralement, les vitesses de rotation de telles anodes peuvent atteindre environ 10 000 tours par minute. La température au point d'impact des électrons peut atteindre 2000°C, la température de l'anode, dans sa masse, s'établissant généralement aux environs de 1300°C.

Un tel fonctionnement génère de fortes contraintes thermomécaniques qui entraînent une dégradation progressive du revêtement cible en un matériau réfractaire, plus particulièrement sur la zone ou piste annulaire balayée, pouvant consister en un grossissement des grains du matériau réfractaire, en l'apparition de micro-fissures et/ou en l'érosion du matériau réfractaire. Une telle dégradation entraîne une dégradation de la puissance des rayons X et une augmentation de la diffusion spatiale des rayons X.

Compte tenu des coûts des matériaux formant le disque, généralement un alliage molybdène-titane-zirconium (TZM), un graphite ou un composite carbone-carbone, et des coûts de fabrication d'un tel disque, il apparaît souhaitable de procéder à une réparation des anodes endommagées. Dans ce but, plusieurs solutions sont déjà proposées.

Le brevet US 5 013 274 décrit une méthode de réparation d'anodes dans laquelle on repère les trous d'endommagement du revêtement cible en un matériau réfractaire, on comble ces trous par un dépôt local du matériau réfractaire, par un dépôt en phase vapeur, suivi d'un frittage, et on procède à un usinage ou une rectification pour éliminer l'excès de matériau déposé par rapport au reste à la surface du revêtement cible initial.

Le brevet US 2011/0211767 décrit une méthode de réparation d'anodes dans laquelle on retire les endroits endommagés du revêtement cible, on dépose du matériau réfractaire sous la forme d'une poudre, on réalise un frittage de cette poudre et on procède à un usinage ou une rectification pour éliminer l'excès de matériau déposé.

Les méthodes décrites dans les documents ci-dessus ne donnent pas satisfaction car les endroits réparés sont fragiles.

Le brevet US 8 428 222 et le brevet US 2011/0007872 décrivent une méthode de réparation d'anodes dans laquelle une portion annulaire du disque munie du revêtement cible en un matériau réfractaire est enlevée et est remplacée par une portion nouvelle munie d'un revêtement cible neuf, cette portion nouvelle étant brasée sur le disque. Le brevet WO 2009/019645 décrit une méthode de réparation d'anodes dans laquelle un matériau de réparation est déposé aux endroits nécessitant une réparation, suivi par un frittage sélectif par faisceau laser.

Le brevet EP 0 062 380 décrit une anode multi-couches présentant une zone de diffusion intermédiaire. Cette méthode nécessite une intervention sur le disque et pose des problèmes de positionnement de la portion nouvelle rapportée.

La présente invention a pour but d'améliorer considérablement les qualités des anodes réparées.

Il est proposé un procédé de réparation d'une anode pour l'émission de rayons X comprenant un disque muni sur une zone annulaire d'un revêtement cible initial comprenant au moins un matériau apte à produire des rayons X sous l'effet d'un faisceau incident d'électrons.

Ce procédé comprend : une étape d'usinage d'au moins une portion annulaire dudit revêtement cible initiale, sur une profondeur inférieure à son épaisseur de façon à laissant subsister une couche annulaire restante de cette portion annulaire ; une étape de dépôt d'une couche intermédiaire sur ladite couche annulaire restante ; une étape de dépôt d'une couche de réparation sur ladite couche intermédiaire ; et une étape de traitement thermique par un recuit tel que, par inter-diffusion et formation d'une solution solide, le matériau de ladite partie intermédiaire et le matériau de ladite partie restante annulaire diffusent l'un dans l'autre et le matériau de la couche intermédiaire et le matériau de la couche de réparation diffusent l'un dans l'autre, jusqu'à la disparition de ladite couche intermédiaire.

Le procédé peut comprendre une étape de préparation de la rugosité et/ou de désoxydation de la surface de ladite couche annulaire restante.

Le procédé peut comprendre une étape d'usinage et/ou de rectification de la surface de la couche de réparation.

Selon le procédé, le matériau de la couche initiale et le matériau de la couche de réparation peuvent comprendre du tungstène ou un alliage à base majoritaire de tungstène.

Selon le procédé, le matériau de la couche intermédiaire peut comprendre du rhénium ou un alliage à base majoritaire de rhénium.

Selon le procédé, la couche intermédiaire et la couche de réparation peuvent être réalisées par des dépôts chimiques en phase vapeur (CVD).

Selon le procédé, le traitement thermique de recuit peut être réalisé à une température comprise entre 1200°C et 2000°C, pendant une durée comprise entre une heure et huit heures.

Il est également proposé une anode pour l'émission de rayons X, comprenant un disque muni sur une zone annulaire d'un revêtement cible apte à produire des rayons X sous l'effet d'un faisceau incident d'électrons, dans laquelle ledit revêtement cible, exempt d'interface interne, comprend, sur au moins une portion annulaire, une couche interne recouverte d'une couche externe, et présentant une zone diffuse de transition entre ces couches, dans laquelle un matériau intermédiaire est diffusé dans le matériau de ladite couche interne et dans la matériau de ladite couche externe sous la forme d'une solution solide.

Le matériau de la couche interne et le matériau de la couche externe peuvent comprendre du tungstène ou un alliage à base majoritaire de tungstène.

Ledit matériau intermédiaire peut comprendre du rhénium ou un alliage à base majoritaire de rhénium.

Une anode pour l'émission de rayons X et des étapes de réparation de cette anode vont maintenant être décrites à titre d'exemples non limitatifs, illustrés par le dessin sur lequel :
- la figure 1 représente une coupe d'une anode rotative selon l'invention, portant un revêtement cible ;
- la figure 2 représente une coupe partielle agrandie d'un revêtement de l'anode de la figure 1 ;
- la figure 3 représente une coupe partielle agrandie du revêtement de l'anode de la figure 2, selon une étape de réparation ;
- la figure 4 représente une coupe partielle agrandie du revêtement de l'anode de la figure 2, selon une autre étape de réparation ; et
- la figure 5 représente une coupe partielle agrandie du revêtement de l'anode de la figure 2, selon une autre étape de réparation.

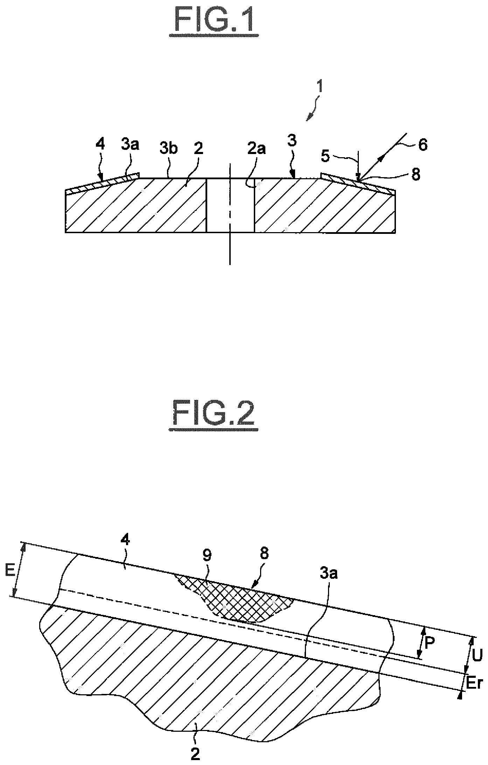

Une anode 1 de production de rayons X, illustrée sur la figure 1 comprend un substrat constitué par un disque rotatif 2 qui présente un passage central traversant de montage 2a, pouvant recevoir une extrémité d'un arbre d'entraînement en rotation (non représenté), et qui présente une face frontale 3 qui présente une zone annulaire 3a, légèrement tronconique, située autour d'une zone centrale radiale 3b traversée par le passage 2a.

Le disque rotatif 2 peut être monobloc et en un alliage molybdène-titane-zirconium (TZM), en un graphite, en un composite carbone-carbone ou peut être en plusieurs parties annulaires comprenant ces matériaux.

Sur la zone annulaire 3a de la face frontale 3 est présent un revêtement cible 4. Ce revêtement 4 peut s'étendre jusqu'au bord périphérique de la face frontale 3 et peut être éventuellement prolongé sur la face périphérique du disque 2. Le revêtement 4 peut être réalisé en même temps que le disque 2 ou peut être rapporté sur un disque préalablement fabriqué. En outre, le revêtement 4 peut comprendre une ou plusieurs couches.

Le revêtement 4 comprend au moins un matériau apte à produire des rayons X selon une direction 6, sous l'effet d'un faisceau incident d'électrons selon une direction 5, dirigé vers et bombardant localement le matériau. Lors de la rotation du disque 2, le point d'impact du faisceau incident d'électrons décrit une piste locale annulaire 8 sur le revêtement.

Le revêtement 4 peut comprendre une couche par exemple de tungstène, ou un alliage comprenant majoritairement de tungstène, par exemple de tungstène-rhénium, formée par frittage ou résultant d'un dépôt chimique en phase vapeur (CVD). L'épaisseur du revêtement 4 peut être comprise entre deux cents et trois mille microns.

Comme illustré sur la figure 2, au cours de son utilisation, la piste 8 du revêtement 4 de l'anode 1 est soumise à de fortes contraintes thermomécaniques. Ces contraintes engendrent une dégradation 9 du matériau à partir de la surface du revêtement 4, notamment sous forme de microfissures, de fusion, d'augmentation de la rugosité, de modification des grains du matériau, d'un sillon annulaire résultant d'un enlèvement de matière. Cette dégradation 9 engendre une diminution des capacités de production de rayons X de l'anode 1, telle que cette dernière n'est plus utilisable.

On va maintenant décrire un procédé permettant de réparer l'anode 1 ainsi dégradée.

Tout d'abord, on mesure la profondeur de la dégradation 9. Pour cela, on peut mettre en oeuvre des techniques de mesures optiques par interférométrie ou des techniques de mesures par ultrasons, connues en soi.

Pour que l'anode 1 soit réparable, il convient que la profondeur P de la dégradation 9 soit inférieure à l'épaisseur E du revêtement 4.

Ensuite, on procède à un usinage partiel du revêtement 4 sur une profondeur U au moins égale à la profondeur P, mais inférieure à l'épaisseur E du revêtement 4, de telle sorte qu'il subsiste une épaisseur restante Er du revêtement 4 sur le disque 2. Cet usinage peut être réalisé par une rectification cylindrique.

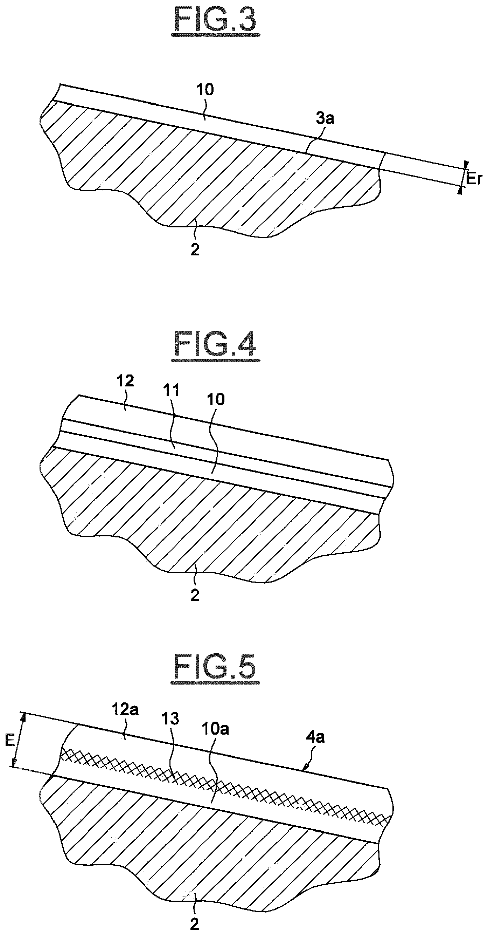

Comme illustré sur la figure 3, le disque 1 est alors muni d'une couche annulaire restante 10 correspondant à l'épaisseur restante Er du revêtement 4 initiale. L'épaisseur restante Er peut être comprise entre cent et deux mille cinq cents microns.

Ensuite, si la rugosité de la surface de la couche restante 10 issue de l'usinage ci-dessus n'est pas suffisante ou trop irrégulière, on procède à une préparation par un traitement mécanique de surface tel qu'un sablage, un microbillage, un décapage cryogénique par exemple par projection de CO₂ sous forme solide. La rugosité préférable peut être comprise entre un demi et cinq microns.

Ensuite, on peut appliquer à la surface de la couche restante 10 un nettoyage chimique pour éliminer les oxydes, par une attaque chimique externe ou dans un réacteur par un flux d'un gaz.

Ensuite, comme illustré sur la figure 4, on procède à un dépôt d'une couche intermédiaire annulaire d'accrochage 11 sur la couche restante 10, puis d'une couche annulaire de réparation 12 sur couche intermédiaire 11.

Le matériau constituant la couche intermédiaire d'accrochage 11 peut être choisi parmi le rhénium, le tantale, le zirconium, le niobium, le titane, le vanadium, l'hafnium ou un alliage de ces matériaux.

La couche de réparation 12 peut être en un matériau identique ou équivalent au matériau constituant le revêtement 4 initial, par exemple du tungstène ou un alliage comprenant majoritairement de tungstène, par exemple de tungstène-rhénium.

Les couches 11 et 12 peuvent résulter de dépôts chimiques en phase vapeur (CVD), connus en soi.

L'épaisseur de la couche intermédiaire 10 peut être comprise entre cinquante nanomètres et dix microns et l'épaisseur de la couche de réparation 12 peut être comprise entre cent et mille microns.

Ensuite, on applique un traitement thermique de recuit tel que, par inter-diffusion et formation d'une solution solide, le matériau de la partie intermédiaire 11 et le matériau de la partie restante 10 diffusent l'un dans l'autre et le matériau de la couche intermédiaire 11 et le matériau de la couche de réparation 12 diffusent l'un dans l'autre, jusqu'à la disparition de la couche intermédiaire antérieure 11 et des interfaces internes antérieures entre la couche antérieure intermédiaires et les couches antérieures 10 et 12.

Comme illustré sur la figure 5, le nouveau revêtement cible 4a, exempt d'interface(s) interne(s), comprend alors une couche interne 10a correspondant substantiellement à la couche interne restante 10 et une couche externe 12a correspondant substantiellement à la couche externe de réparation 12 et comprend une zone diffuse de transition 13 entre ces couches 10a et 12a, dans laquelle le matériau constituant antérieurement la couche intermédiaire 11 est diffusé dans le matériau de la couche restante 10 et dans le matériau de la couche de réparation 12 sous la forme d'une solution solide.

Selon un exemple particulier, les atomes du rhénium pouvant constituer antérieurement la couche intermédiaire 11 ont migré d'une part dans la couche restante 10 en tungstène ou en tungstène-rhénium et d'autre part dans la couche de réparation 12 en tungstène ou en tungstène-rhénium, de telle sorte que la couche intermédiaire antérieure 11 en rhénium, proprement dite, a disparu.

Le traitement thermique de recuit peut être réalisé à une température comprise entre 1200°C et 2000°C, pendant une durée de quelques heures, par exemple comprise entre une heure et huit heures, en fonction des différentes épaisseurs à traiter.

Le nouveau revêtement 4a est de préférence plus épais que le revêtement initial 4. On peut alors effectuer un usinage ou une rectification de la surface du nouveau revêtement 4a, de telle sorte que son épaisseur soit égale à ou la plus proche possible de l'épaisseur du revêtement initial 4.

Alors, l'anode 1 réparée est conforme à l'anode 1 préalablement endommagée et peut être réutilisée directement.

Il résulte de ce qui précède que la zone diffuse de transition 13 du nouveau revêtement 4a constitue une liaison robuste entre la couche interne 10a et la couche externe 12a, notamment grâce à la suppression par diffusion de la couche intermédiaire antérieure 11 et en conséquence la suppression des interfaces fragiles existant antérieurement entre cette couche intermédiaire antérieure 11 et ces couches interne et externe 10 et 12 et à l'adhésion directe de ces couches 10a et 12a, résultant du traitement thermique de recuit. De plus, cette zone diffuse de transition 13 permet une bonne liaison thermique entre la couche interne 10a et la couche externe 12a.

Le procédé de réparation qui vient d'être décrit est appliqué à toute la surface du revêtement annulaire 4 initial. Néanmoins, selon une variante de réalisation, le procédé de réparation pourrait être appliqué à une portion annulaire du revêtement annulaire 4 initial, incluant la portion annulaire endommagée 9 correspondant à la piste annulaire 8.

La présente invention ne se limite pas aux exemples ci-dessus décrits. Des variantes de réalisation sont possibles sans sortir du cadre de l'invention.

## Revendications

1. Procédé de réparation d'une anode pour l'émission de rayons X comprenant un disque muni sur une zone annulaire d'un revêtement cible initial comprenant au moins un matériau apte à produire des rayons X sous l'effet d'un faisceau incident d'électrons, comprenant :
une étape d'usinage d'au moins une portion annulaire dudit revêtement cible initiale (4), sur une profondeur inférieure à son épaisseur de façon à laissant subsister une couche annulaire restante (10) de cette portion annulaire,
une étape de dépôt d'une couche intermédiaire (11) sur ladite couche annulaire restante (10),
une étape de dépôt d'une couche de réparation (12) sur ladite couche intermédiaire,
une étape de traitement thermique par un recuit tel que, par inter-diffusion et formation d'une solution solide, le matériau de ladite partie intermédiaire et le matériau de ladite partie restante annulaire diffusent l'un dans l'autre et le matériau de la couche intermédiaire et le matériau de la couche de réparation diffusent l'un dans l'autre, jusqu'à la disparition de ladite couche intermédiaire.

2. Procédé selon la revendication 1, comprenant une étape de préparation de la rugosité et/ou de désoxydation de la surface de ladite couche annulaire restante (10).

3. Procédé selon l'une des revendications 1 et 2, comprenant une étape d'usinage et/ou de rectification de la surface de la couche de réparation (12).

4. Procédé selon l'une quelconque des revendications précédentes, dans lequel le matériau de la couche initiale et le matériau de la couche de réparation comprend du tungstène ou un alliage à base majoritaire de tungstène.

5. Procédé selon l'une quelconque des revendications précédentes, dans lequel le matériau de la couche intermédiaire comprend du rhénium ou un alliage à base majoritaire de rhénium.

6. Procédé selon l'une quelconque des revendications précédentes, dans lequel la couche intermédiaire et la couche de réparation sont réalisées par des dépôts chimiques en phase vapeur (CVD).

7. Procédé selon l'une quelconque des revendications précédentes, dans lequel le traitement thermique de recuit est réalisé à une température comprise entre 1200°C et 2000°C, pendant une durée comprise entre une heure et huit heures.

8. Anode pour l'émission de rayons X, comprenant un disque muni sur une zone annulaire d'un revêtement cible (4a) apte à produire des rayons X sous l'effet d'un faisceau incident d'électrons, dans laquelle ledit revêtement cible (4a), exempt d'interface interne, comprend, sur au moins une portion annulaire, une couche interne (10a) recouverte d'une couche externe (12a), et présentant une zone diffuse de transition (13) entre ces couches, dans laquelle un matériau intermédiaire est diffusé dans le matériau de ladite couche interne et dans le matériau de ladite couche externe sous la forme d'une solution solide.

9. Anode selon la revendication 8, dans laquelle le matériau de la couche interne et le matériau de la couche externe comprennent du tungstène ou un alliage à base majoritaire de tungstène.

10. Anode selon l'une des revendications 8 et 9, dans laquelle ledit matériau intermédiaire comprend du rhénium ou un alliage à base majoritaire de rhénium.

## Patentansprüche

1. Reparaturverfahren einer Anode zur Ausstrahlung von Röntgenstrahlen, umfassend eine Scheibe, die auf einer ringförmigen Zone mit einer anfänglichen Zielbeschichtung versehen ist, umfassend mindestens ein Material, das geeignet ist, Röntgenstrahlen unter der Einwirkung eines einfallenden Elektronenstrahls zu erzeugen, umfassend:
einen Schritt der Bearbeitung mindestens eines ringförmigen Abschnitts der anfänglichen Zielbeschichtung (4) in einer Tiefe, die geringer ist als seine Dicke, um eine verbleibende ringförmige Schicht (10) dieses ringförmigen Abschnitts bestehen zu lassen,
einen Schritt der Abscheidung einer Zwischenschicht (11) auf der verbleibenden ringförmigen Schicht (10),
einen Schritt der Abscheidung einer Reparaturschicht (12) auf der Zwischenschicht,
einen Schritt der thermischen Behandlung durch Glühen, so dass, durch Interdiffusion und Bildung einer festen Lösung, das Material des Zwischenteils und das Material des ringförmigen verbleibenden Teils ineinander diffundieren und das Material der Zwischenschicht und das Material der Reparaturschicht ineinander diffundieren, bis zum Verschwinden der Zwischenschicht.

2. Verfahren nach Anspruch 1, umfassend einen Schritt der Erzeugung einer Rauheit und/oder der Oxidation der Fläche der verbleibenden ringförmigen Schicht (10) .

3. Verfahren nach einem der Ansprüche 1 und 2, umfassend einen Schritt der Bearbeitung und/oder der Korrektur der Fläche der Reparaturschicht (12) .

4. Verfahren nach einem der vorhergehenden Ansprüche, wobei das Material der anfänglichen Schicht und das Material der Reparaturschicht Wolfram oder eine Legierung auf mehrheitlicher Basis von Wolfram umfassen.

5. Verfahren nach einem der vorhergehenden Ansprüche, wobei das Material der Zwischenschicht Rhenium oder eine Legierung auf mehrheitlicher Basis von Rhenium umfasst.

6. Verfahren nach einem der vorhergehenden Ansprüche, wobei die Zwischenschicht und die Reparaturschicht durch chemische Abscheidungen in der Dampfphase (CVD) hergestellt werden.

7. Verfahren nach einem der vorhergehenden Ansprüche, wobei die thermische Glühbehandlung bei einer Temperatur zwischen 1200 °C und 2000 °C während einer Dauer zwischen einer Stunde und acht Stunden durchgeführt wird.

8. Anode zur Ausstrahlung von Röntgenstrahlen, umfassend eine Scheibe, die auf einer ringförmigen Zone mit einer Zielbeschichtung (4a) versehen ist, die geeignet ist, Röntgenstrahlen unter der Einwirkung eines einfallenden Elektronenstrahls zu erzeugen, wobei die Zielbeschichtung (4a), ohne interne Grenzfläche, auf mindestens einem ringförmigen Abschnitt, eine interne Schicht (10a) umfasst, die mit einer externen Schicht (12a) bedeckt ist, und eine diffuse Übergangszone (13) zwischen diesen Schichten aufweist, wobei ein Zwischenmaterial in das Material der internen Schicht und in das Material der externen Schicht in der Form einer festen Lösung diffundiert wird.

9. Anode nach Anspruch 8, wobei das Material der internen Schicht und das Material der externen Schicht Wolfram oder eine Legierung auf mehrheitlicher Basis von Wolfram umfassen.

10. Verfahren nach einem der Ansprüche 8 und 9, wobei das Zwischenmaterial Rhenium oder eine Legierung auf mehrheitlicher Basis von Rhenium umfasst.

## Claims

1. Process for repairing an anode for emitting x-rays, comprising a disc equipped, on an annular zone, with an initial target coating comprising at least one material able to produce x-rays under the effect of an incident beam of electrons, comprising:
a step of machining at least one annular portion of said initial target coating (4) to a depth smaller than its thickness so as to leave behind a residual annular layer (10) of this annular portion;
a step of depositing an intermediate layer (11) on said residual annular layer (10) ;
a step of depositing a repairing layer (12) on said intermediate layer; and
a heat treatment step in which an anneal is carried out such that, by interdiffusion and formation of a solid solution, the material of said intermediate part and the material of said residual annular part diffuse into each other and the material of the intermediate layer and the material of the repairing layer diffuse into each other, until said intermediate layer disappears.

2. Process according to Claim 1, comprising a step of preparing the roughness and/or of deoxidising the surface of said residual annular layer (10).

3. Process according to either of Claims 1 and 2, comprising a step of machining and/or grinding the surface of the repairing layer (12).

4. Process according to any one of the preceding claims, in which the material of the initial layer and the material of the repairing layer comprise tungsten or an alloy made up mainly of tungsten.

5. Process according to any one of the preceding claims, in which the material of the intermediate layer comprises rhenium or an alloy made up mainly of rhenium.

6. Process according to any one of the preceding claims, in which the intermediate layer and the repairing layer are produced by chemical vapour deposition (CVD).

7. Process according to any one of the preceding claims, in which the annealing heat treatment is carried out at a temperature comprised between 1200°C and 2000°C, for a length of time comprised between one hour and eight hours.

8. Anode for emitting x-rays, comprising a disc equipped, on an annular zone, with a target coating (4a) able to produce x-rays under the effect of an incident beam of electrons, in which said target coating (4a), exempt of internal interfaces, comprises, in at least one annular portion, an internal layer (10a) covered with an external layer (12a), there being, between these layers, a diffuse transition zone (13) in which an intermediate material is diffused into the material of said internal layer and into the material of said external layer in the form of a solid solution.

9. Anode according to Claim 8, in which the material of the internal layer and the material of the external layer comprise tungsten or an alloy made up mainly of tungsten.

10. Anode according to either of Claims 8 and 9, in which said intermediate material comprises rhenium or an alloy made up mainly of rhenium.
